# DEMANDE DE BREVET EUROPEEN

(11) **EP 4 808 335 A1**
(43) Date de publication de la demande: **16.09.2026**
(21) Numéro de dépôt: 26164072.6
(22) Date de dépôt: 11.03.2026
(51) Int. Cl.: H10N 70/00, H10N 70/20, H10B 63/00, H10B 63/10

(54) **DISPOSITIF ELECTRONIQUE COMPORTANT UN CIRCUIT MEMOIRE A BASE D'UN MATERIAU A CHANGEMENT DE PHASE**

(30) Priorité: 13.03.2025 FR 2502500
(71) Demandeur: STMicroelectronics International N.V., 1228 Plan-les-Ouates, Geneva (CH)
(72) Inventeur: BACQUIE, Valentin, 38000 GRENOBLE (FR); QUERRE, Madec, 38000 GRENOBLE (FR); GANNEREAU, Loic, 38100 GRENOBLE (FR); DESMOULINS, Simon, 38700 CORENC (FR); RUBECK, Sarah, 73110 ARVILLARD (FR)
(74) Mandataire: Cabinet Beaumont

(57) **Abrégé**

La présente description concerne un dispositif électronique comportant des cellules mémoires, chaque cellule mémoire comportant :
- un élément résistif chauffant (19) comportant une partie horizontale (H) et une partie verticale (V), la partie verticale (V) étant en contact avec la partie horizontale (H) ; et
- une couche en un matériau à changement de phase (17), recouvrant une face supérieure des éléments (19),

chaque élément (19) étant recouvert par un espaceur isolant (21), l'espaceur (21) étant en contact avec un flanc vertical (V_{V}) de la partie verticale (V) de l'élément (19) et avec une face supérieure (H_{S}) de la partie horizontale (H) de l'élément (19), et
les espaceurs isolants (21) recouvrant deux éléments (19) successifs d'une même ligne, étant séparés par une couche isolante (23) en oxyde.

## Description

### Domaine technique

La présente description concerne de façon générale le domaine des dispositifs électroniques et vise plus particulièrement le domaine des puces électroniques comportant un circuit mémoire, à base d'un matériau à changement de phase, et leurs procédés de fabrication.

### Technique antérieure

Un matériau à changement de phase est un matériau ayant la capacité de changer d'état cristallin sous l'effet de la chaleur et plus particulièrement de commuter entre un état cristallin et un état amorphe, plus fortement résistif que l'état cristallin. Ce phénomène est utilisé pour définir deux états mémoires, par exemple 0 et 1, différenciés par la résistance mesurée à travers le matériau à changement de phase.

Il existe un besoin d'amélioration des puces électroniques comportant un circuit mémoire à base d'un matériau à changement de phase.

### Résumé de l'invention

Pour cela, un mode de réalisation prévoit un dispositif électronique comportant des cellules mémoires agencées sous forme d'une matrice de lignes et de colonnes, chaque cellule mémoire comportant :
- un élément résistif chauffant comportant une partie horizontale inférieure et une partie verticale supérieure, la partie verticale étant en contact avec la partie horizontale; et
- une couche en un matériau à changement de phase, la couche en le matériau à changement de phase étant commune aux cellules mémoires d'une même ligne et recouvrant une face supérieure des éléments résistifs chauffants,
   chaque élément résistif chauffant étant recouvert par un espaceur isolant, l'espaceur isolant étant en contact avec un flanc vertical de la partie verticale de l'élément résistif chauffant et avec une face supérieure de la partie horizontale de l'élément résistif chauffant, et
   les espaceurs isolants recouvrant deux éléments résistifs chauffants successifs d'une même ligne, étant séparés par une couche isolante en oxyde, la couche isolante étant en contact avec lesdits espaceurs isolants.

Selon un mode de réalisation, la couche est en oxyde de silicium.

Selon un mode de réalisation, les espaceurs isolants sont en nitrure de silicium.

Selon un mode de réalisation, les espaceurs isolants comportent une pluralité de sous-couches.

Selon un mode de réalisation, les sous-couches des espaceurs isolants ont chacune une épaisseur inférieure à 15 nm.

Selon un mode de réalisation, le matériau à changement de phase est un chalcogènure.

Selon un mode de réalisation, les éléments résistifs chauffants sont en un alliage de nitrure, titane et silicium.

Selon un mode de réalisation, les espaceurs isolants ont une épaisseur comprise dans la plage allant de 20 nm à 30 nm.

Selon un mode de réalisation, chaque élément résistif chauffant est en contact avec la couche isolante par un flanc latéral, opposé à la partie verticale, de la partie horizontale de l'élément résistif chauffant.

Selon un mode de réalisation, le dispositif comporte en outre une électrode supérieure sur la couche en le matériau à changement de phase à l'opposé de l'élément résistif chauffant et une couche de masquage sur l'électrode supérieure, la couche en le matériau à changement de phase, l'électrode supérieure et la couche de masquage étant communes aux cellules mémoires d'une même ligne et recouvertes par une couche d'encapsulation, la couche d'encapsulation recouvrant une face supérieure de la couche de masquage et des flancs latéraux de la couche de masquage, de l'électrode supérieure et de la couche en le matériau à changement de phase,
dans lequel les espaceurs isolants, la couche de masquage et la couche d'encapsulation comprennent chacun une pluralité de sous-couches en nitrure de silicium.

Un autre mode de réalisation prévoit un procédé de fabrication d'un dispositif électronique comportant des cellules mémoires agencées sous forme d'une matrice de lignes et de colonnes comportant les étapes consécutives suivantes :
a) formation de tranchées dans une première couche ;
b) dépôt d'une couche en un matériau électriquement résistif ;
c) dépôt d'une première couche isolante sur la couche en le matériau électriquement résistif ;
d) gravure anisotrope de la première couche isolante et de la couche en le matériau électriquement résistif de façon à ne les laisser subsister que sur les flancs de la première couche et former, dans la couche en le matériau électriquement résistif, des éléments résistifs chauffants et, dans la première couche isolante, des espaceurs isolants ;
e) dépôt d'une couche isolante en oxyde dans les tranchées, de façon à les combler intégralement ;
f) retrait d'une partie supérieure de la couche isolante, des espaceurs et des éléments résistifs chauffants de façon à dévoiler la face supérieure de la première couche.

Selon un mode de réalisation, lors de l'étape c), la première couche isolante est déposée par une méthode de dépôt pulsé chimique en phase vapeur assisté par plasma.

Selon un mode de réalisation, lors de l'étape c), la puissance du plasma alterne entre une puissance haute et une puissance basse.

Selon un mode de réalisation, la première couche isolante est formée par le dépôt successif d'une pluralité de sous-couches.

Selon un mode de réalisation, les sous-couches ont une épaisseur inférieure à 15 nm.

Selon un mode de réalisation, le procédé comporte en outre, après l'étape f), les étapes successives suivantes :
- dépôt d'une électrode supérieure sur la couche en le matériau à changement de phase ;
- dépôt d'une couche de masquage sur l'électrode supérieure ;
- gravure de façon à créer, dans la couche de masquage, l'électrode supérieure et la couche en le matériau à changement de phase, des lignes ; et
- dépôt d'une couche d'encapsulation recouvrant une face supérieure de la couche de masquage et des flancs latéraux de la couche de masquage, de l'électrode supérieure et de la couche en le matériau à changement de phase.

Selon un mode de réalisation, la couche de masquage et/ou la couche d'encapsulation sont déposées selon une méthode de dépôt pulsé chimique en phase vapeur assisté par plasma.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, illustrant un exemple d'un dispositif électronique ;
la figure 2A, la figure 2B, la figure 2C, la figure 2D, la figure 2E, la figure 2F, la figure 2G, la figure 2H, la figure 2I, la figure 2J et la figure 2K sont des vues, partielles et schématiques, illustrant des étapes d'un exemple de procédé de fabrication d'un dispositif électronique selon un premier mode de réalisation ;
la figure 3A et la figure 3B sont des vues, partielles et schématiques, illustrant des étapes d'un exemple de procédé de fabrication d'un dispositif électronique selon un deuxième mode de réalisation ;
la figure 4 est une vue, partielle et schématique, d'un exemple d'un dispositif électronique selon un troisième mode de réalisation ;
la figure 5 est une vue, partielle et schématique, d'un exemple d'un dispositif électronique selon un quatrième mode de réalisation ; et
la figure 6 est une vue, partielle et schématique, d'un exemple d'un dispositif électronique selon un cinquième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

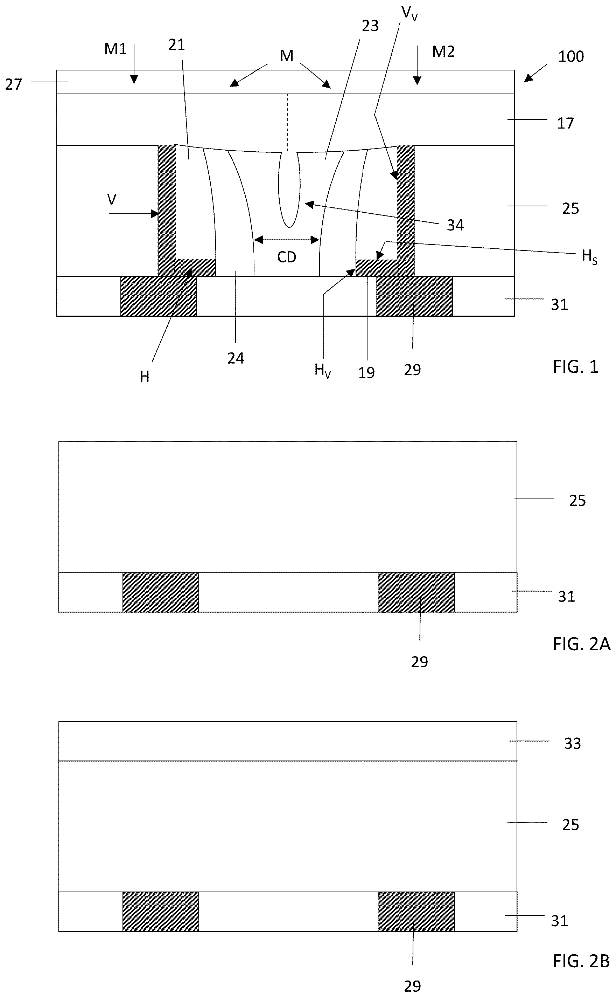

La figure 1 est une vue en coupe, partielle et schématique, illustrant un exemple d'un dispositif électronique 100.

Le dispositif 100 est par exemple une puce électronique.

Le dispositif 100 comprend un circuit mémoire comportant une pluralité de cellules mémoires M organisées, en vue de dessus, selon une matrice de lignes et de colonnes. On parle respectivement de lignes de mots WL (wordlines) et de lignes de bits BL (bitlines). A titre d'exemple, chaque cellule mémoire M est située à l'intersection d'une ligne de bits et d'une ligne de mots.

A titre d'exemple, les cellules mémoires M illustrées en figure 1 sont des cellules mémoires M d'une même ligne de de bits BL. En figure 1, seulement deux cellules mémoires M1, M2 sont représentées. En pratique, un circuit mémoire peut comprendre un nombre de cellules mémoires M, par ligne de bits, supérieur à deux.

Les cellules mémoires M sont des cellules mémoires à changement de phase. Chaque cellule M comprend une couche 17 en un matériau à changement de phase, par exemple un matériau chalcogènure, par exemple un alliage de germanium, antimoine et tellure (GeSbTe) dit GST. La couche 17 a, par exemple, une épaisseur comprise entre 30 nm et 100 nm, par exemple, de l'ordre de 50 nm. Chaque couche 17 s'étend par exemple dans la direction des lignes de bits. Les cellules mémoires M d'une même ligne de bits comprennent une couche 17 commune. Ainsi, le dispositif 100 comprend par exemple autant de couches 17 que de lignes de bits.

Dans chaque cellule mémoire M, le matériau à changement de phase est contrôlé par un élément électriquement résistif 19. L'élément résistif 19 est situé sous le matériau à changement de phase 17. L'élément 19 est par exemple en contact, par sa face supérieure, avec la face inférieure de la couche 17. A titre d'exemple, l'élément 19 est chauffant.

Chaque élément 19 a une forme de "L" dans le plan de coupe de la figure 1. Chaque élément 19 comporte ainsi, dans sa partie inférieure, une partie horizontale H et, dans une partie supérieure, une partie verticale V. La partie verticale V et la partie horizontale H de chaque élément 19 sont en contact l'une de l'autre. A titre d'exemple, les parties verticale et horizontale sont en contact par leurs flancs latéraux. Les éléments 19 n'ont, au sein d'une même ligne de bits, par exemple pas tous la même orientation. A titre d'exemple, certains éléments 19 ont la forme d'un "L" inversé, c'est-à-dire que leur partie horizontale H s'étend, dans l'orientation de la figure 1, à gauche de la partie verticale V. A titre d'exemple, chaque ligne de bits comprend une succession d'éléments 19 avec une alternance d'éléments 19 ayant la forme d'un "L" et d'éléments 19 ayant la forme d'un "L" inversé. A titre d'exemple, chaque élément 19 est symétrique avec ses deux voisins d'une même ligne de bits, selon un plan vertical et parallèle à la partie verticale V des éléments 19. Deux éléments 19 consécutifs d'une même ligne de bits ont donc soit leurs parties horizontales H face à face soit leurs parties verticales V face à face.

L'élément résistif 19 est par exemple en un matériau métallique, par exemple en un alliage de nitrure, de silicium et de titane (TiSiN).

Deux éléments résistifs 19 voisins d'une même ligne de bits, dont les parties horizontales H sont face à face, sont séparés par deux premiers espaceurs isolants ou couches isolantes 21 chacun revêtant un élément résistif 19. Chaque espaceur 21 est par exemple en contact avec un élément 19.

Plus précisément, chaque espaceur 21 recouvre, et est en contact avec, la face supérieure de la partie horizontale H de chaque élément 19. Chaque espaceur 21 recouvre en outre, et est en contact avec, un flanc de la partie verticale V de l'élément 19. Chaque espaceur 21 s'étend par exemple sur une partie seulement de la hauteur de l'élément 19. Chaque espaceur 21 s'étend, par exemple, sur toute la hauteur de la partie verticale V de l'élément 19 non recouverte par la partie horizontale H. Les espaceurs 21 sont par exemple en nitrure de silicium.

A titre d'exemple, les espaceurs 21 ont une épaisseur, prise dans le plan de la face supérieure de la partie horizontale H de l'élément 19, comprise entre 20 nm et 30 nm, par exemple de l'ordre de 25 nm.

Deux éléments résistifs 19 voisins d'une même ligne de bits, dont les parties horizontales H sont face à face, sont en outre séparés par une autre couche isolante 23. A titre d'exemple, la couche 23 s'étend entre les espaceurs 21 revêtant les éléments 19. La couche 23 s'étend par exemple sur toute la hauteur des éléments 19. La couche 23 est par exemple en oxyde de silicium.

Dans l'exemple de la figure 1, chaque couche 23 est séparée de chacun des deux espaceurs 21 qui l'entourent par un deuxième espaceur ou couche 24. Ainsi, la couche isolante 23 revêt par exemple les flancs latéraux de deux espaceurs 24 voisins. A titre d'exemple, chaque couche 23 a ses deux flancs latéraux en contact avec deux espaceurs 24 voisins. Les espaceurs 24 s'étendent par exemple sur toute la hauteur de la couche 23.

Chaque espaceur 24 a par exemple un de ses flancs latéraux en contact avec le flanc latéral d'un espaceur 21. Chaque espaceur 24 a par exemple l'autre de ses flancs latéraux en contact avec le flanc latéral d'une couche 23.

A titre d'exemple, dans une partie inférieure, chaque espaceur 24 recouvre en outre et est en contact avec le flanc latéral de la partie horizontale H de l'élément 19, opposé à la partie verticale, non recouvert par l'espaceur 21. A titre d'exemple, les couches 23 ont leurs faces supérieures en contact avec la face inférieure de la couche 17.

A titre d'exemple, les espaceurs 24 sont en nitrure de silicium.

A titre d'exemple, les espaceurs 24 ont une épaisseur, prise dans le plan de leurs faces inférieures, comprise entre 20 nm et 30 nm, par exemple de l'ordre de 25 nm.

Deux éléments résistifs 19 voisins d'une même ligne de bits, dont les parties verticales V se font face, sont par exemple séparés par une couche isolante 25. La couche isolante 25 recouvre par exemple les flancs verticaux des parties verticales V des deux éléments 19 voisins et est par exemple en contact avec eux. A titre d'exemple, la couche 25 recouvre, pour chaque élément 19, le flanc de sa partie verticale V, opposé à sa partie horizontale H. La couche 25 s'étend par exemple sur toute la hauteur des éléments 19.

A titre d'exemple, les faces inférieures des éléments 19, des couches 23 et des espaceurs 24 sont coplanaires. A titre d'exemple, les faces supérieures des éléments 19, des espaceurs 24, des couches 23 et des espaceurs 21 sont coplanaires. A titre d'exemple, les éléments chauffants 19 ont une hauteur comprise entre 30 nm et 100 nm, par exemple de l'ordre de 60 nm.

La couche 17 est par exemple surmontée par une couche 27 en un matériau conducteur, par exemple en un matériau métallique. Plus précisément, la face supérieure de chaque couche 17 est par exemple au moins partiellement recouverte, par exemple entièrement recouverte, par une couche 27. Chaque couche 27 s'étend, de préférence, dans la direction des lignes de bits, sur toute la longueur de la couche 17.

A titre d'exemple, dans chaque cellule mémoire M, l'élément métallique 19 et la couche 27 forment respectivement une électrode inférieure et une électrode supérieure de la cellule mémoire M, et plus précisément des électrodes de l'élément résistif à résistance variable formé par la couche 17 en le matériau à changement de phase. A titre d'exemple, les cellules mémoires M d'une même ligne de bits sont surmontées d'une même couche 27. En d'autres termes, les électrodes supérieures 27 des cellules mémoires M d'une même ligne de bits sont interconnectées.

A titre d'exemple, chaque cellule mémoire M est connectée électriquement à un transistor de sélection, non représenté. A titre d'exemple, chaque cellule mémoire est reliée au transistor de sélection qui lui est associé par l'intermédiaire d'un via conducteur 29. A titre d'exemple, la face supérieure du via 29 est en contact avec la face inférieure de l'élément 19 de la cellule mémoire M associée. A titre d'exemple, les vias 29 sont en un matériau conducteur, par exemple métallique, par exemple en tungstène. A titre d'exemple, les vias 29 sont entourés d'une couche isolante 31. La couche isolante 31 est par exemple en oxyde, par exemple en oxyde de silicium.

A titre d'exemple, les vias 29 traversent un empilement d'interconnexion, situé entre les transistors de sélection et les cellules mémoires M.

Les cellules mémoires M de lignes de bits voisines sont par exemple isolées les unes des autres par une couche isolante non représentée, par exemple, en un matériau ayant une faible constante diélectrique ou en un oxyde, par exemple en oxyde de silicium.

Dans un tel dispositif, les inventeurs ont constaté que, lors du dépôt de la couche 23, dans l'ouverture formée entre les espaceurs 24 de deux cellules mémoires consécutives d'une même ligne de bits, un espace vide 34 sans couche 23, semblable à une bulle, peut se former dans la couche 23. La formation d'un tel espace vide 34 s'explique par le fait que la largeur CD entre les espaceurs 24 est faible ce qui empêche un bon remplissage de l'ouverture par la couche 23.

Les espaces vides 34 peuvent déboucher sur la face supérieure de la couche 23. Lors de la formation de la couche en le matériau à changement de phase 17, cette couche 17 peut s'introduire dans les espaces vides 34, provoquant ainsi des défauts dans les cellules mémoires M.

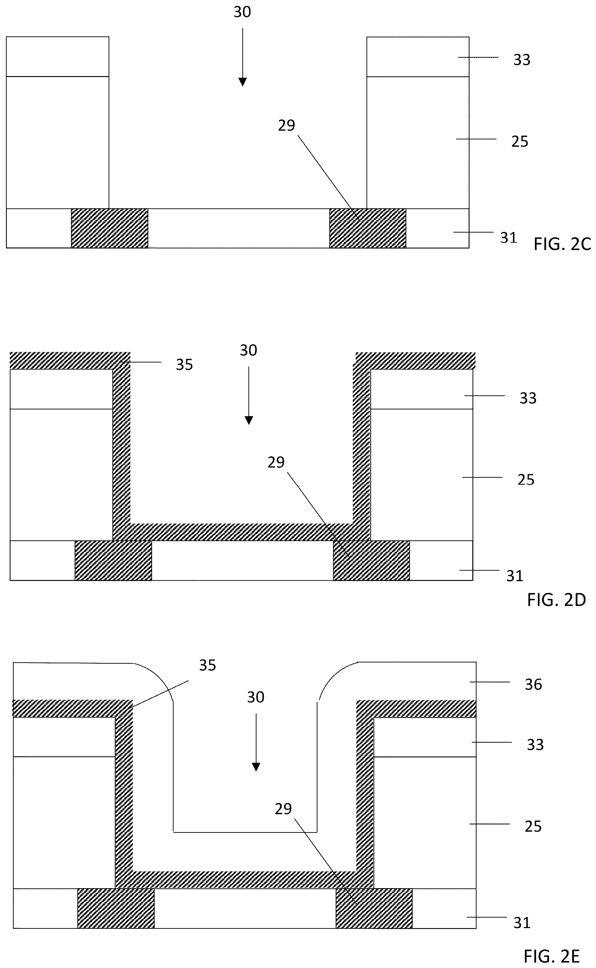

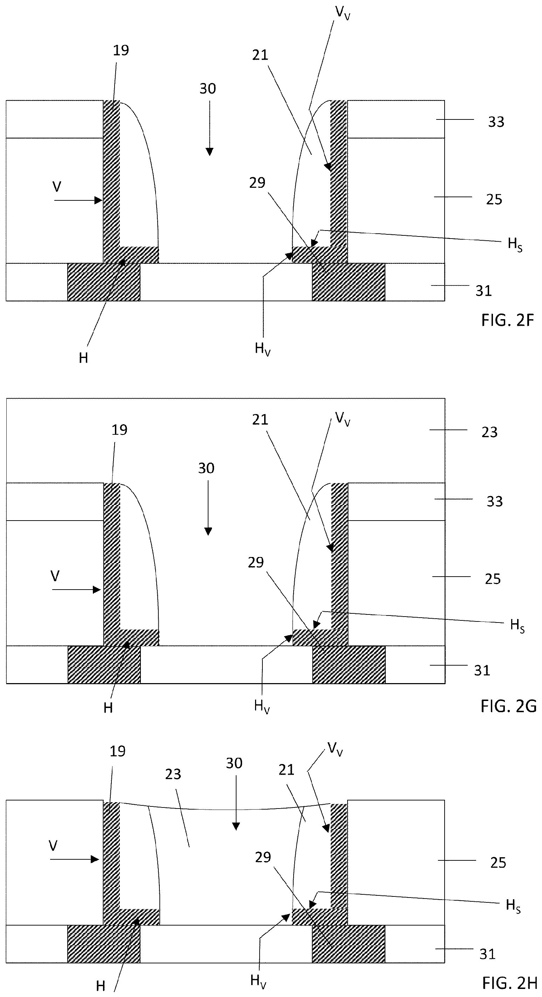

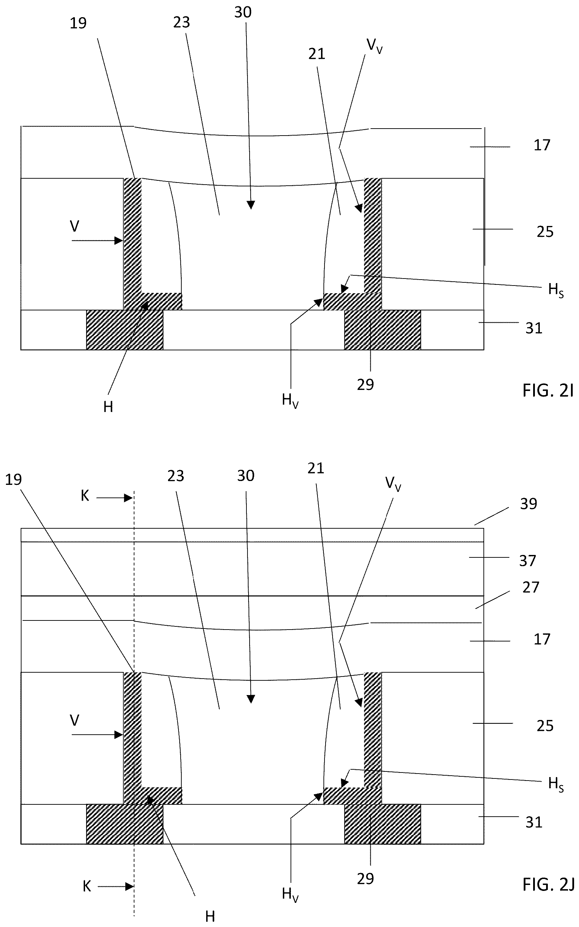

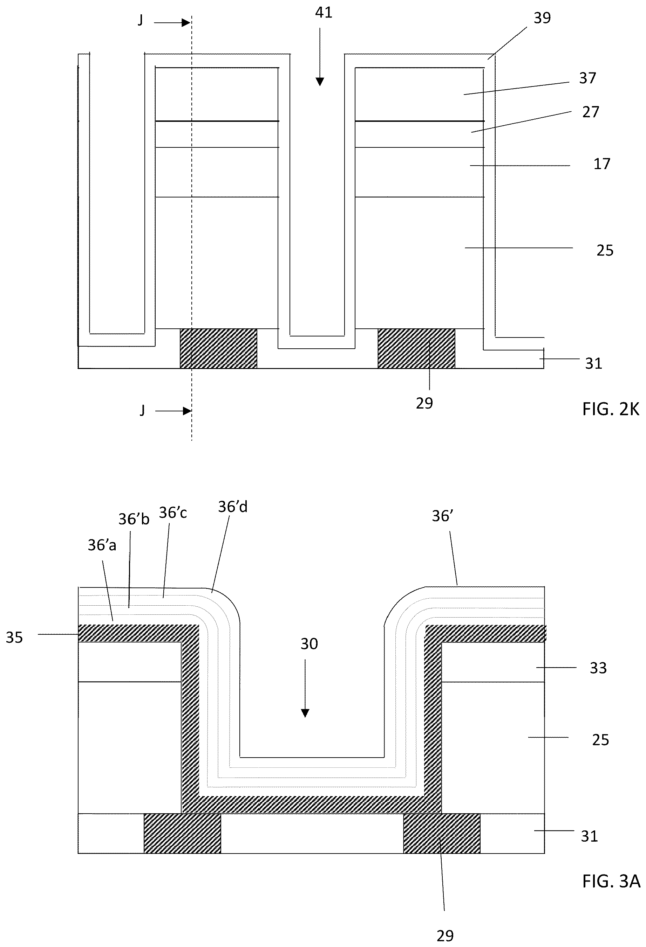

La figure 2A, la figure 2B, la figure 2C, la figure 2D, la figure 2E, la figure 2F, la figure 2G, la figure 2H, la figure 2I, la figure 2J et la figure 2K sont des vues, partielles et schématiques, illustrant des étapes d'un exemple de procédé de fabrication d'un dispositif électronique selon un premier mode de réalisation.

Le premier mode de réalisation prévoit d'augmenter la largeur CD en supprimant le deuxième espaceur 24.

La figure 2A illustre une structure de départ comportant la couche isolante 25. La structure de départ comporte en outre les vias conducteurs 29. Dans la structure de départ, les vias 29 sont par exemple entourés pas la couche 31. Les vias conducteurs 29 sont par exemple, dans la structure de départ, surmontés par la couche isolante 25.

Dans ce mode de réalisation, la couche isolante 25 est par exemple en un nitrure, par exemple en nitrure de silicium. A titre d'exemple, la couche 25 a une épaisseur comprise dans la plage allant de 30 nm à 100 nm, par exemple de l'ordre de 60 nm.

La figure 2B illustre une structure obtenue à l'issue d'une étape de dépôt d'une couche 33 sur la face supérieure de la structure illustrée en figure 2A.

La couche 33 est par exemple une couche d'arrêt de gravure. La couche 33 est par exemple en un matériau isolant, par exemple en un oxyde, par exemple en oxyde de silicium. La couche 33 est par exemple en un matériau différent du matériau de la couche 25. La couche 33 recouvre par exemple la couche 25 sur toute sa surface. A titre d'exemple, la couche 33 est en contact, par sa face inférieure avec la face supérieure de la couche 25.

La couche 33 a par exemple une épaisseur comprise dans la plage allant de 25 nm à 35 nm, par exemple de l'ordre de 30 nm.

La figure 2C illustre une structure obtenue à l'issue d'une étape de gravure des couches 25 et 33 de la structure illustrée en figure 2B.

Plus particulièrement, lors de cette étape, on vient par exemple graver les couches 25 et 33 localement de façon à former des tranchées 30 dans l'empilement des couches 25 et 33. Lors de cette étape, l'empilement des couches 25 et 33 est par exemple retiré localement sur au moins une partie de la face supérieure de chaque via 29. Lors de cette étape, une partie de la face supérieure de la couche 31 et des vias 29 est par exemple dévoilée. A l'issue de cette étape, les vias 29 ont ainsi, leurs faces supérieures au moins partiellement dévoilées.

La figure 2D illustre une structure obtenue à l'issue d'une étape de formation d'une couche 35 en le matériau de l'élément résistif chauffant 19 sur la face supérieure de la structure illustrée en figure 2C.

Lors de cette étape, la couche 35 est par exemple déposée pleine plaque de façon à recouvrir l'entièreté de la face supérieure de la structure illustrée en figure 2C. La couche 35 est par exemple déposée de façon conforme.

A titre d'exemple, lors de cette étape, la couche 35 est déposée de sorte qu'elle recouvre la face supérieure de la couche 33 et les flancs de la couche 33 et de la couche 25 et, dans les tranchées 30, la face supérieure de la couche 31 et du via 29 non recouverte par la couche 25. A titre d'exemple, la couche 35 est déposée en contact avec les couches susmentionnées.

A titre d'exemple, la couche 35 est déposée avec une épaisseur comprise entre 2 nm et 6 nm, par exemple de l'ordre de 4 nm.

La figure 2E illustre une structure obtenue à l'issue d'une étape de dépôt d'une couche 36 en le matériau des espaceurs 21 sur la face supérieure de la structure illustrée en figure 2D.

Lors de cette étape, la couche 36 est par exemple déposée pleine plaque de façon à recouvrir toute la surface de la face supérieure de la couche 33. A titre d'exemple, la couche 36 est déposée de façon conforme. La couche 36 est par exemple déposée avec une épaisseur comprise entre 10 nm et 40 nm.

La figure 2F illustre une structure obtenue à l'issue d'une étape de gravure des couches 36 et 35 de la structure illustrée en figure 2E.

Plus particulièrement, lors de cette étape, la couche 36 est gravée de sorte qu'elle ne subsiste que sur les flancs de l'empilement des couches 25 et 35, en formant les espaceurs 21. La couche 36 est, lors de cette étape, par exemple retirée sur la face supérieure de la couche 33 et sur la face supérieure des vias 29 et de la couche isolante 31.

En outre, lors de cette étape, la couche 35 est gravée en ne subsistant que dans les portions où elle est protégée par les espaceurs 21, en formant les éléments 19. A titre d'exemple, la gravure est, lors de cette étape, arrêtée lorsque la face supérieure de la couche 33 est dévoilée.

A titre d'exemple, la gravure correspond à une gravure sèche. A titre d'exemple, la gravure correspond à une gravure anisotrope, par exemple une gravure par plasma.

En outre, à l'issue de cette étape, chaque espaceur 21 est en contact avec le flanc vertical V_{V} de la partie verticale V d'un élément 19 et avec la face supérieure H_{S} de la partie horizontale H du même élément 19.

La figure 2G illustre une structure obtenue à l'issue d'une étape de dépôt d'une couche 23 sur la face supérieure de la structure illustrée en figure 2F.

Plus particulièrement, lors de cette étape, on vient par exemple former la couche 23 pleine plaque. A titre d'exemple, la couche 23 recouvre la face supérieure de la couche 31 et des vias 29, la face supérieure de la couche 33, des espaceurs 21 et des éléments 19. En outre, dans ce mode de réalisation, la couche 23 recouvre, dans chacune des tranchées 30, le flanc latéral, opposé à la partie verticale V, de la partie horizontale H de chacun des deux élément 19 qui se font face. Dans ce mode de réalisation, la couche 23 est en contact avec le flanc latéral H_{V}, opposé à la partie verticale V, de la partie horizontale H de chacun des deux élément 19 qui se font face par leurs faces horizontales H. La couche 23 est, dans ce mode de réalisation et à la différence de l'exemple de la figure 1, formée en contact avec les espaceurs 21 revêtant les éléments 19 de deux cellules mémoires M successives.

A titre d'exemple, la couche 23 est déposée avec une épaisseur suffisamment importante de façon à combler intégralement les tranchées 30 entre les empilements des couches 25 et 33. La couche 23 a par exemple une épaisseur, dans les tranchées 30, supérieure à 110 nm, par exemple de l'ordre de 125 nm.

La couche 23 est, dans ce mode de réalisation, en un oxyde, par exemple en oxyde de silicium.

La figure 2H illustre une structure obtenue à l'issue d'une étape de retrait d'une partie supérieure de la structure illustrée en figure 2G.

Plus particulièrement, lors de cette étape, une partie supérieure de la structure illustrée en figure 2G est retirée de façon à dévoiler la face supérieure de la couche 25. A titre d'exemple, la couche 33 et une partie supérieure de la couche 23, des espaceurs et des éléments 19 sont alors retirées au sein d'une seule et même étape. Le retrait est, lors de cette étape, réalisé par polissage mécanique, par exemple par polissage mécanochimique ou CMP (de l'anglais « Chemical Mechanical Polishing »).

La figure 2I illustre une structure obtenue à l'issue d'une étape de dépôt de la couche 17 sur la face supérieure de la structure illustrée en figure 2H.

Plus particulièrement, lors de cette étape, la couche 17 est déposée de façon à recouvrir l'ensemble de la face supérieure de la structure illustrée en figure 2H. A titre d'exemple, la couche 17 est en contact avec la face supérieure de la structure illustrée en figure 2H. Plus particulièrement la face supérieure de la couche 25, la face supérieure de la couche 23 et la face supérieure des espaceurs 21 et des éléments 19 sont recouverts par la couche 17.

La figure 2J et la figure 2K illustrent une structure obtenue à l'issue d'une étape de formation de l'électrode 27, d'une couche de masquage 37 et d'une couche d'encapsulation 39 sur la face supérieure de la structure illustrée en figure 2I, la figure 2J étant une vue selon le plan de coupe JJ de la figure 2K et la figure 2K étant une vue selon le plan de coupe KK de la figure 2J.

Lors de cette étape, l'électrode 27 est par exemple formée sur la face supérieure de la couche 17, par exemple en contact, par sa face inférieure, avec la face supérieure de la couche 17.

De plus, lors de cette étape, la couche 37 est par exemple formée sur la face supérieure de la couche 27, par exemple en contact, par sa face inférieure, avec la face supérieure de la couche 27. La couche 37 est par exemple formée sur l'entièreté de la face supérieure de la couche 27. La couche de masquage 37 est par exemple en un nitrure, par exemple en nitrure de silicium. A titre d'exemple, la couche 37 a une épaisseur de l'ordre de 15 nm. La couche 37 est par exemple déposée par une méthode de dépôt nanométrique.

La couche 37 comprend par exemple une pluralité de sous-couches. A titre d'exemple, la couche 37 est déposée par une méthode de dépôt pulsé chimique en phase vapeur assisté par plasma (PECVD pulsé, "Pulsed Plasma-Enhanced Chemical Vapor Deposition" en anglais). Cette méthode de dépôt est similaire à la méthode de dépôt PECVD à la différence près que la puissance du plasma n'est pas constante sur toute la durée du dépôt. La puissance du plasma est, dans cette méthode, pulsée c'est à dire qu'elle suit des impulsions. Dans cette méthode, la puissance du plasma alterne entre une puissance haute et une puissance basse. A titre d'exemple, la puissance haute est comprise entre 80 W et 200 W, par exemple de l'ordre de 107 W. A titre d'exemple, la puissance basse est sensiblement nulle. Lors du dépôt de la couche 37, le gaz précurseur comprend par exemple du trisilylamine (TSA), de l'ammoniac (NH₃), du diazote (N₂) ou une combinaison de deux ou plus de ces éléments.

La fréquence des impulsions est par exemple comprise entre 800 Hz et 1500 Hz, par exemple de l'ordre de 1000 Hz. A titre d'exemple, sur la durée du dépôt de la couche 37, le plasma est allumé, par exemple entre 5 % et 20 % du temps, par exemple environ 10 % du temps. Le dépôt de la couche 37 a par exemple une durée supérieure à 30 secondes, par exemple comprise entre 60 secondes et 120 secondes et est, par exemple de l'ordre de 91 secondes. Lors de cette étape, la couche 37 est par exemple déposée avec une épaisseur inférieure à 15 nm, par exemple de l'ordre de 11 nm.

A titre d'exemple, un dépôt de 11 nm de la couche 37 est réalisé lorsque :
- la puissance du plasma est, dans sa valeur haute, de 107 W ;
- la fréquence de pulsation est de 1000 Hz ;
- le plasma est activé pendant 10 % du temps ; et
- la durée du dépôt est de 91 secondes.

A titre d'exemple, à l'issue de l'étape de dépôt de la couche 37, celle-ci subit une étape de traitement permettant de densifier la couche 37 en azote. En d'autres termes, la couche 37 subit, à l'issue de son dépôt, une étape lui permettant de se charger davantage en azote. A titre d'exemple, ce traitement consiste en une exposition de la surface de la couche 37 à un plasma de diazote et d'hélium.

L'enchainement d'un dépôt selon la méthode de PECVD pulsé suivie d'une étape de traitement correspond à un cycle de dépôt par PECVD pulsé.

En variante, la couche 37 est formée par une méthode de dépôt par PECVD non pulsé.

A l'issue du dépôt des couches 27 et 37, la couche 37 est gravée localement de façon à créer, dans la couche 37, des ouvertures traversantes s'étendant jusqu'à la surface de la couche 27. A l'issue de la formation des ouvertures dans la couche 37, des tranchées 41 sont formées dans la structure ainsi obtenue. Plus particulièrement, lors de cette étape, la formation des tranchées 41 est réalisée alors que la couche de masquage 37 joue le rôle de masque de gravure.

A titre d'exemple, les tranchées 41 sont formées à partir de la face supérieure de la couche 27 dans l'empilement des cellules mémoires M jusqu'à atteindre la couche isolante 31. A titre d'exemple, la gravure est arrêtée lorsque les tranchées 41 débouchent dans la couche isolante 31.

Lors de cette étape, la formation des tranchées 41 permet de former les lignes de bits.

A l'issue de cette étape, la couche 37 a une épaisseur réduite par rapport à ce qui a été décrit précédemment lors du dépôt de la couche 37. La couche 37 a, en effet, à l'issue de cette étape, une épaisseur inférieure à 10 nm, par exemple inférieure à 7 nm, par exemple de l'ordre de 5 nm.

En outre, lors de cette étape, la couche d'encapsulation 39 est formée sur la face supérieure de la structure. Chaque cellule mémoire M est par exemple recouverte par une couche d'encapsulation 39 protégeant, par exemple la couche 17 en le matériau à changement de phase de l'oxydation. A titre d'exemple, la couche d'encapsulation 39 recouvre et est par exemple en contact avec la face supérieure de la couche 37 et les flancs des couches 37, 27, 17 et 25. La couche d'encapsulation 39 est par exemple en un matériau diélectrique. La couche d'encapsulation 39 est par exemple en un nitrure, par exemple en nitrure de silicium. La couche d'encapsulation 39 a par exemple une épaisseur comprise entre 20 nm et 50 nm, par exemple de l'ordre de 33 nm. Plus particulièrement, lors de cette étape, on vient déposer la couche 39 sur la face supérieure de la couche 37 et dans les tranchées 41, sur les flancs latéraux de l'empilement des couches 37, 27, 17 et 25. A titre d'exemple, la couche 39 est en outre déposée dans le fond des tranchées 41 sur la face supérieure de la couche 31.

La couche 39 est par exemple déposée selon une méthode de dépôt conforme. A titre d'exemple, la couche 39 comprend une pluralité de sous-couches. A titre d'exemple, la couche 39 est déposée selon une méthode de dépôt PECVD pulsé similairement à ce qui a été décrit pour la couche 37.

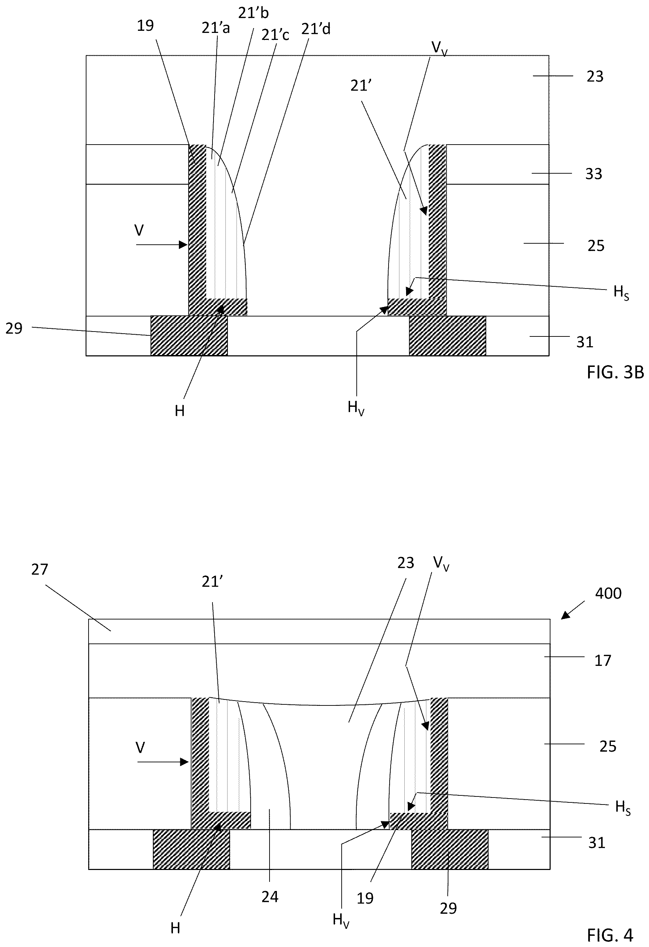

La figure 3A et la figure 3B sont des vues, partielles et schématiques, illustrant des étapes d'un exemple de procédé de fabrication d'un dispositif électronique selon un deuxième mode de réalisation.

Plus particulièrement le procédé selon le deuxième mode de réalisations est similaire au procédé selon le premier mode de réalisation illustré en figures 2A à 2I, à la différence près que les étapes illustrées en figures 2E et 2F sont remplacées par les étapes 3A et 3B. Lors de ces étapes, la couche 36 est remplacée par une couche 36' comportant une pluralité de sous-couches 36'a, 36'b, 36'c, 36'd.

La figure 3A illustre une structure obtenue à l'issue d'une étape de dépôt de la couche 36' sur la face supérieure de la structure illustrée en figure 2D.

Les sous-couches 36'a, 36'b, 36'c, 36'd de la couche 36 sont par exemple déposées par PECVD pulsé, similairement à ce qui a été décrit pour la couche 37.

A titre d'exemple, un dépôt de 5 nm est réalisé lorsque :
- la puissance du plasma est, dans sa valeur haute, de 107 W ;
- la fréquence de pulsation est de 1000 Hz ;
- le plasma est activé pendant 10 % du temps ; et
- la durée du dépôt est de 41 secondes.

En figure 3A, quatre sous-couches 36'a, 36'b, 36'c et 36'd ont été présentées pour la couche 36'. En pratique, le nombre de sous-couches peut être différent de 4 et peut être égal à 2, ou égal à 3 ou être supérieur à 4.

A titre d'exemple toutes les sous-couches de la couche 36' ont la même épaisseur. L'épaisseur de la couche 36' est, par exemple dans ce mode de réalisation fonction du nombre de sous-couches.

En variante du mode de réalisation illustré en figure 3A, la couche 36' peut être une monocouche formée par PECVD pulsé.

La figure 3B illustre une structure obtenue à l'issue d'une étape de gravure des couches 36' et 35 illustrées en figure 3A de façon à former des espaceurs 21' comportant une pluralité de sous-couches 21'a, 21'b, 21'c, 21'd et les éléments 19. Cette étape est identique à l'étape de gravure des couches 36 et 35 illustrée en figure 2F à la différence près de l'épaisseur de la couche 36'.

A l'issue de cette étape, les espaceurs 21' ont par exemple une épaisseur, prise à l'interface entre les espaceurs 21' et la face supérieure de la partie horizontale H de l'élément 19 comprise entre 20 nm et 30 nm, par exemple de l'ordre de 25 nm.

Un avantage du présent mode de réalisation est qu'il permet de déposer la couche 36' avec une épaisseur plus petite par rapport à une couche 36 déposée par PECVD non pulsé.

Un avantage du présent mode de réalisation est qu'un espaceur 21' déposé par PECVD pulsé présente une meilleure isolation thermique par rapport à un espaceur 21 de même épaisseur mais déposé par une méthode de PECVD non pulsé. En effet, dans ce mode de réalisation, chaque espaceur 21' comporte, entre chacune des sous-couches 21'a, 21'b, 21'c et 21'd, une interface, chacune de ces interfaces augmentant l'isolation thermique de l'espaceur 21'.

Alors que, dans les premier et deuxième modes de réalisation, la suppression des deuxièmes espaceurs 24 conduit à l'augmentation de la largeur CD, on peut prévoir l'obtention de cet effet, non pas par la suppression des deuxièmes espaceurs, mais par la diminution de l'épaisseur des uns et/ou des autres des premiers 21 et deuxièmes 24 espaceurs de la figure 1. En d'autres termes, il peut être prévu de conserver les espaceurs 24 comme illustré en figure 1 mais d'en diminuer leur épaisseur et/ou de diminuer l'épaisseur des espaceurs 21.

La figure 4 est une vue, partielle et schématique, d'un exemple d'un dispositif électronique 400 selon un troisième mode de réalisation. Plus particulièrement, dans ce mode de réalisation, il est prévu de conserver les deuxièmes espaceurs 24 et de former les premiers espaceurs par une méthode de PECVD pulsé en diminuant leurs épaisseurs.

Ainsi, le dispositif 400 est similaire au dispositif 100 illustré en figure 1 à la différence près que les espaceurs 21 sont remplacés par des espaceurs 21' formés par PECVD pulsé. Dans ce mode de réalisation, les espaceurs 21' présentent une épaisseur inférieure à l'épaisseur des espaceurs 21 illustrés en figure 1.

Les espaceurs 21' peuvent ainsi avoir une épaisseur inférieure à 15 nm, par exemple de l'ordre de 11 nm ou de l'ordre de 5 nm. Les espaceurs 24 ont, dans ce mode de réalisation, par exemple une épaisseur identique à ce qui a été décrit en relation avec la figure 1, c'est-à-dire une épaisseur comprise entre 20 nm et 30 nm, par exemple de l'ordre de 25 nm.

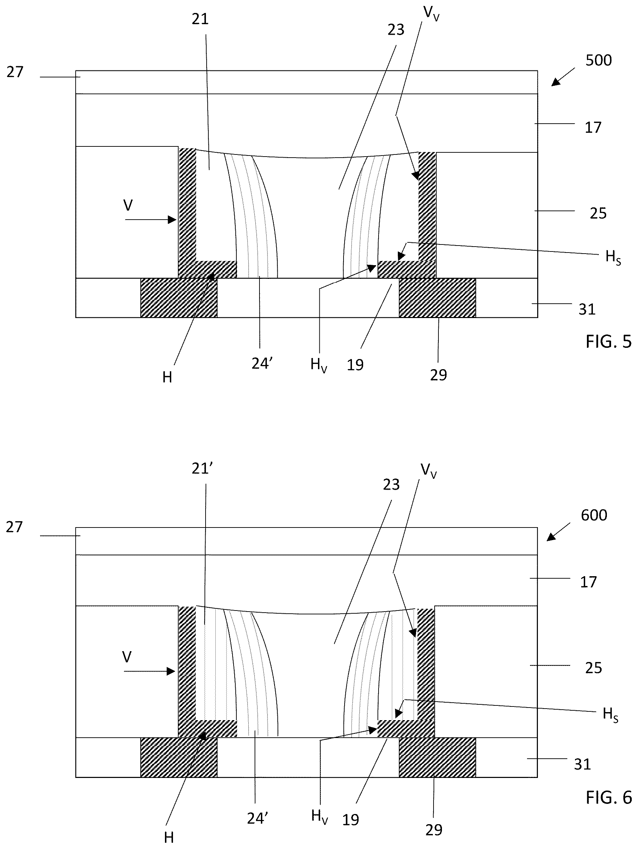

La figure 5 est une vue, partielle et schématique, d'un exemple d'un dispositif électronique 500 selon un quatrième mode de réalisation. Plus particulièrement, dans ce mode de réalisation, il est prévu de conserver les deuxièmes espaceurs 24 et de les former par une méthode de PECVD pulsé en diminuant leurs épaisseurs.

Ainsi, le dispositif 500 est similaire au dispositif 100 illustré en figure 1 à la différence près que les espaceurs 24 sont remplacés par des espaceurs 24' formés par PECVD pulsé. Dans ce mode de réalisation, les espaceurs 24' présentent une épaisseur inférieure à l'épaisseur des espaceurs 24 illustrés en figue 1.

Les espaceurs 24' peuvent ainsi avoir une épaisseur inférieure à 15 nm, par exemple de l'ordre de 11 nm ou de l'ordre de 5 nm. Dans ce mode de réalisation, les espaceurs 21 ont par exemple une épaisseur identique à ce qui a été décrit en relation avec la figure 1, c'est-à-dire une épaisseur comprise entre 20 nm et 30 nm, par exemple de l'ordre de 25 nm.

La figure 6 est une vue, partielle et schématique, d'un exemple d'un dispositif électronique 600 selon un cinquième mode de réalisation. Plus particulièrement, dans ce mode de réalisation, il est prévu de conserver les deuxièmes espaceurs 24 et de former les premiers et les deuxièmes espaceurs par une méthode de PECVD pulsé en diminuant leurs épaisseurs.

Ainsi, le dispositif 600 est similaire au dispositif 100 illustré en figure 1 à la différence près que les espaceurs 21 et 24 sont respectivement remplacés par des espaceurs 21' et 24' formés par PECVD pulsé. Dans ce mode de réalisation, les espaceurs 21' et 24' présentent par exemple chacun une épaisseur inférieure respectivement aux épaisseurs des espaceurs 21 et 24 illustrés en figure 1.

Les espaceurs 21 et 24 peuvent ainsi chacun avoir une épaisseur par exemple inférieure à 15 nm, par exemple de l'ordre de 11 nm ou de l'ordre de 5 nm.

Un autre moyen de limiter les risques de défaillance liés à la présence des espaces vides 34 dans la couche 23, est de s'assurer de la présence des espaces vides 34 mais d'en contrôler la profondeur dans l'ouverture 30 afin qu'ils ne débouchent pas sur la face supérieure de la couche 23.

Les inventeurs ont constaté qu'une augmentation de l'épaisseur de l'un et/ou l'autre des espaceurs 21 et 24 dans une certaine mesure conduit à la formation d'un espace vide 34 entre les deux éléments 19 mais que les espaces vides formés ne débouchent pas sur la face supérieure de la couche 23. Dans cet exemple, les espaceurs 21 et 24 ont alors chacun une épaisseur supérieure ou égale à 20 nm, par exemple supérieure ou égale à 25 nm. De tels espaces vides 34 non débouchants augmentent ainsi l'isolation thermique entre deux éléments 19 consécutifs sans endommager les cellules mémoires M.

Cette variante qui consiste à augmenter l'épaisseur de l'une et/ou l'autre des premiers et deuxièmes espaceurs est par exemple compatible avec la formation de l'un ou l'autre des espaceurs par la méthode de PECVD pulsé comme cela a été décrit en relation avec les figures 4 à 6.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif électronique comportant des cellules mémoires (M) agencées sous forme d'une matrice de lignes et de colonnes, chaque cellule mémoire (M) comportant :
- un élément résistif chauffant (19) comportant une partie horizontale inférieure (H) et une partie verticale supérieure (V), la partie verticale (V) étant en contact avec la partie horizontale (H) ; et
- une couche en un matériau à changement de phase (17), la couche en le matériau à changement de phase étant commune aux cellules mémoires (M) d'une même ligne et recouvrant une face supérieure des éléments résistifs chauffants (19),
chaque élément résistif chauffant (19) étant recouvert par un premier espaceur isolant (21 ; 21'), l'espaceur isolant (21 ; 21') étant en contact avec un flanc vertical (V_{V}) de la partie verticale (V) de l'élément résistif chauffant (19) et avec une face supérieure (H_{S}) de la partie horizontale (H) de l'élément résistif chauffant (19), et
les premiers espaceurs isolants (21 ; 21') recouvrant deux éléments résistifs chauffants (19) successifs d'une même ligne, étant séparés par une couche isolante (23) en oxyde..

2. Dispositif selon la revendication 1, dans lequel :
- la couche isolante (23) est en contact avec les premiers espaceurs isolants (21 ; 21') recouvrant deux éléments résistifs chauffants (19) successifs d'une même ligne ; et
- chaque élément résistif chauffant (19) est en contact avec la couche isolante (23) par un flanc vertical (H_{V}), opposé à la partie verticale (V), de la partie horizontale (H) de l'élément résistif chauffant (19).

3. Dispositif électronique selon la revendication 1 ou 2, dans lequel la couche (23) est en oxyde de silicium.

4. Dispositif électronique selon l'une quelconque des revendications 1 à 3, dans lequel les premiers espaceurs isolants (21 ; 21') sont en nitrure de silicium.

5. Dispositif électronique selon l'une quelconque des revendications 1 à 4, dans lequel les premiers espaceurs isolants (21') comportent une pluralité de sous-couches (21'a, 21'b, 21'c, 21'd).

6. Dispositif selon la revendication 5, dans lequel les sous-couches (21'a, 21'b, 21'c, 21'd) des premiers espaceurs isolants (21') ont chacune une épaisseur inférieure à 15 nm.

7. Dispositif selon l'une quelconque des revendications 1 à 6, dans lequel le matériau à changement de phase (17) est un chalcogènure.

8. Dispositif selon l'une quelconque des revendications 1 à 7, dans lequel les éléments résistifs chauffants (19) sont en un alliage de nitrure, titane et silicium.

9. Dispositif selon l'une quelconque des revendications 1 à 8, dans lequel les premiers espaceurs isolants (21 ; 21') ont une épaisseur comprise dans la plage allant de 20 nm à 30 nm.

10. Dispositif selon l'une quelconque des revendications 1 à 9, comportant en outre une électrode supérieure (27) sur la couche en le matériau à changement de phase (17) à l'opposé de l'élément résistif chauffant (19) et une couche de masquage (37) sur l'électrode supérieure (27),
la couche en le matériau à changement de phase (17), l'électrode supérieure (27) et la couche de masquage (37) étant communes aux cellules mémoires d'une même ligne et recouvertes par une couche d'encapsulation (39), la couche d'encapsulation (39) recouvrant une face supérieure de la couche de masquage (37) et des flancs latéraux de la couche de masquage (37), de l'électrode supérieure (27) et de la couche en le matériau à changement de phase (17),
dans lequel les premiers espaceurs isolants (21'), la couche de masquage (37) et la couche d'encapsulation (39) comprennent chacun une pluralité de sous-couches en nitrure de silicium.

11. Dispositif selon la revendication 1, dans lequel chaque premier espaceur isolant (21 ; 21') est séparé de la couche isolante (23) par un deuxième espaceur isolant (24 ; 24'), au moins l'un des premier (21 ; 21') et deuxième '24 ; 24') espaceurs isolants comportant une pluralité de sous-couches.

12. Procédé de fabrication d'un dispositif électronique comportant des cellules mémoires (M) agencées sous forme d'une matrice de lignes et de colonnes comportant les étapes consécutives suivantes :
a) formation de tranchées (30) dans une première couche (25) ;
b) dépôt d'une couche en un matériau électriquement résistif (35) ;
c) dépôt d'une première couche isolante (36) sur et en contact avec la couche en le matériau électriquement résistif (35) ;
d) gravure anisotrope de la première couche isolante (36) et de la couche en le matériau électriquement résistif (35) de façon à ne les laisser subsister que sur les flancs de la première couche (25) et former, dans la couche en le matériau électriquement résistif (35), des éléments résistifs chauffants (19) comportant une partie horizontale inférieure (H) et une partie verticale supérieure (V), la partie verticale (V) étant en contact avec la partie horizontale (H) et, dans la première couche isolante (36), des premiers espaceurs isolants (21) ;
e) dépôt d'une couche isolante (23) en oxyde dans les tranchées (30), de façon à les combler intégralement ;
f) retrait d'une partie supérieure de la couche isolante (23), des premiers espaceurs (21) et des éléments résistifs chauffants (19) de façon à dévoiler la face supérieure de la première couche (25) ; et
g) dépôt d'une couche en un matériau à changement de phase (17), la couche en le matériau à changement de phase étant commune aux cellules mémoires (M) d'une même ligne et recouvrant une face supérieure des éléments résistifs chauffants (19).

13. Procédé de fabrication selon la revendication 12, dans lequel lors de l'étape e) la couche isolante (23) est déposée en contact avec :
- les premiers espaceurs isolants (21 ; 21') recouvrant deux éléments résistifs chauffants (19) successifs d'une même ligne ; et
- le flanc vertical (H_{V}), opposé à la partie verticale (V), de la partie horizontale (H), de deux éléments résistifs chauffants (19) successifs d'une même ligne.

14. Procédé de fabrication selon la revendication 12 ou 13, dans lequel, lors de l'étape c), la première couche isolante (36') est déposée par une méthode de dépôt pulsé chimique en phase vapeur assisté par plasma.

15. Procédé selon la revendication 14, dans lequel, lors de l'étape c), la puissance du plasma alterne entre une puissance haute et une puissance basse.

16. Procédé selon la revendication 14 ou 15, dans lequel la première couche isolante (36') est formée par le dépôt successif d'une pluralité de sous-couches (36'a, 36'b, 36'c, 36' d).

17. Procédé selon la revendication 16, dans lequel les sous-couches (36'a, 36'b, 36'c, 36'd) ont une épaisseur inférieure à 15 nm.

18. Procédé selon l'une quelconque des revendications 12 à 17, comportant en outre, après l'étape f), les étapes successives suivantes :
- dépôt d'une électrode supérieure (27) sur la couche en le matériau à changement de phase (17) ;
- dépôt d'une couche de masquage (37) sur l'électrode supérieure (27) ;
- gravure de façon à créer, dans la couche de masquage (37), l'électrode supérieure (27) et la couche en le matériau à changement de phase (17), des lignes ; et
- dépôt d'une couche d'encapsulation (39) recouvrant une face supérieure de la couche de masquage (37) et des flancs latéraux de la couche de masquage (37), de l'électrode supérieure (27) et de la couche en le matériau à changement de phase (17).

19. Procédé selon la revendication 18, dans lequel la couche de masquage (37) et/ou la couche d'encapsulation (39) sont déposées selon une méthode de dépôt pulsé chimique en phase vapeur assisté par plasma.

20. Procédé selon la revendication 12, comportant, entre les étapes d) et e), une étape de dépôt d'une deuxième couche isolante sur et en contact avec les premiers espaceurs isolants (21 ; 21') et une étape de gravure anisotrope de la deuxième couche isolante de façon à former, dans la deuxième couche isolante, des deuxièmes espaceurs isolants (24 ; 24'),
dans lequel au moins l'une des première (21 ; 21') et deuxième (24 ; 24') couches isolantes est déposée par une méthode de dépôt pulsé chimique en phase vapeur assisté par plasma.
